(19) Europäisches Patentamt
European Patent Office
Office européen des brevets

(11) **EP 2 826 456 B1**

(12) **FASCICULE DE BREVET EUROPEEN**

(45) Date de publication et mention
de la délivrance du brevet:
**23.03.2016 Bulletin 2016/12**

(51) Int Cl.:
*A61J 1/03* (2006.01)      *A61J 7/04* (2006.01)
*H03K 17/96* (2006.01)      *G09F 3/00* (2006.01)
*G06F 3/045* (2006.01)

(21) Numéro de dépôt: **14230005.2**

(22) Date de dépôt: **27.06.2014**

(54) **Membrane et système de contrôle d'une ouverture de la membrane**

Membran und Kontrollsystem einer Öffnung dieser Membran

Membrane and system for controlling an opening of the membrane

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.06.2013 FR 1356338**

(43) Date de publication de la demande:
**21.01.2015 Bulletin 2015/04**

(73) Titulaire: **Commissariat à l'Énergie Atomique
et aux Énergies Alternatives
75015 Paris (FR)**

(72) Inventeurs:
• **Peris Y Saborit, Laure
38000 Grenoble (FR)**
• **Jost, Alan
38100 Grenoble (FR)**
• **Marechal, Damien
38130 Echirolles (FR)**
• **Paleologue, Alexandre
33800 Bordeaux (FR)**

(74) Mandataire: **GIE Innovation Competence Group
310 bis, Avenue Berthelot
69008 Lyon (FR)**

(56) Documents cités:
**EP-A1- 0 972 507      EP-A2- 0 129 785
WO-A1-2004/002396      WO-A2-01/54646
WO-A2-2004/028438**

**Description**

L'invention concerne le suivi des prises de médicaments chez les patients, et en particulier les dispositifs de contrôle de la prise régulière de médications.

Afin de faciliter la prise d'une médication précise à une fréquence donnée, il est connu d'utiliser des blisters disposant de logements disposés en lignes et colonnes. Les logements renferment des médicaments pour une prise respective et sont obturés par une membrane sécable. Lors d'une prise, le patient ouvre la membrane sécable et absorbe les médicaments qui y sont contenus. La rupture de la membrane permet visuellement d'identifier les prises de médicament effectuées et les prises de médicament restantes.

Le strict respect de la prise de médicaments conformément à une prescription médicale est souvent problématique. En effet, le patient peut oublier de prendre ses médications au moment approprié. En outre, le praticien qui suit le patient n'a pas de moyen efficace de connaître le suivi satisfaisant de la médication par le patient. Ainsi, un nombre non négligeable de patients doivent être hospitalisés suite à un non respect des prises de médicaments prescrites. Pour certaines pathologies mentales, le non respect de la médication peut induire de graves troubles du comportement chez le patient. Cela peut également conduire le praticien à accroître le dosage ou le changement de médication en constatant un défaut d'efficacité qui est en fait lié à un problème de prise des médicaments.

L'invention vise à résoudre un ou plusieurs de ces inconvénients. Il existe notamment un besoin pour un dispositif permettant d'identifier efficacement l'accès à un logement, au moyen d'une structure simple et peu coûteuse, même pour un nombre important de logements de médicaments.

Le document WO01/54646 décrit un distributeur de pilules muni d'une électronique d'alarme et d'un emballage. Des pistes conductrices sont connectées à leur croisement sur chaque membrane au-dessus d'un logement. Ces pistes conductrices sont également connectées à un microprocesseur qui détecte l'ouverture de la membrane sur un logement. La rupture d'une membrane sur une cellule induit la coupure de conduction dans toute la ligne et dans toute la colonne sur lesquelles passent ces pistes conductrices, rendant alors la détection d'ouverture impossible pour les autres logements.

L'invention porte ainsi sur une membrane sécable telle que définie dans les revendications annexées.

L'invention porte également sur un système comportant une membrane telle que décrite précédemment et un dispositif de lecture, comme défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 est un schéma électrique d'un système de détection d'ouverture d'un logement dans un emballage scellé par une membrane, selon un mode de réalisation de l'invention ;
- la figure 2 est une vue en coupe d'un logement de l'emballage scellé ;
- la figure 3 est un schéma électrique d'une première variante de membrane d'emballage et de certains éléments d'un lecteur d'emballage associé ;
- la figure 4 est un schéma électrique équivalent lors d'une détection d'ouverture d'un emballage scellé selon la première variante ;
- la figure 5 est un diagramme illustrant la sensibilité et la consommation d'un lecteur en fonction d'une valeur de résistance ;
- la figure 6 est un schéma électrique d'une deuxième variante d'emballage et de certains éléments d'un lecteur d'emballage associé ;
- la figure 7 illustrant une variante d'emballage scindable pour la mise en oeuvre de l'invention ;
- la figure 8 illustre un exemple d'assemblage d'éléments scindés en colonnes, en l'absence de certaines colonnes.

L'objet de l'invention porte sur une membrane (ou un film) sécable, destinée à être appliquée sur des logements, similaires à des alvéoles, chaque logement comportant par exemple une dose de médicament à délivrer.

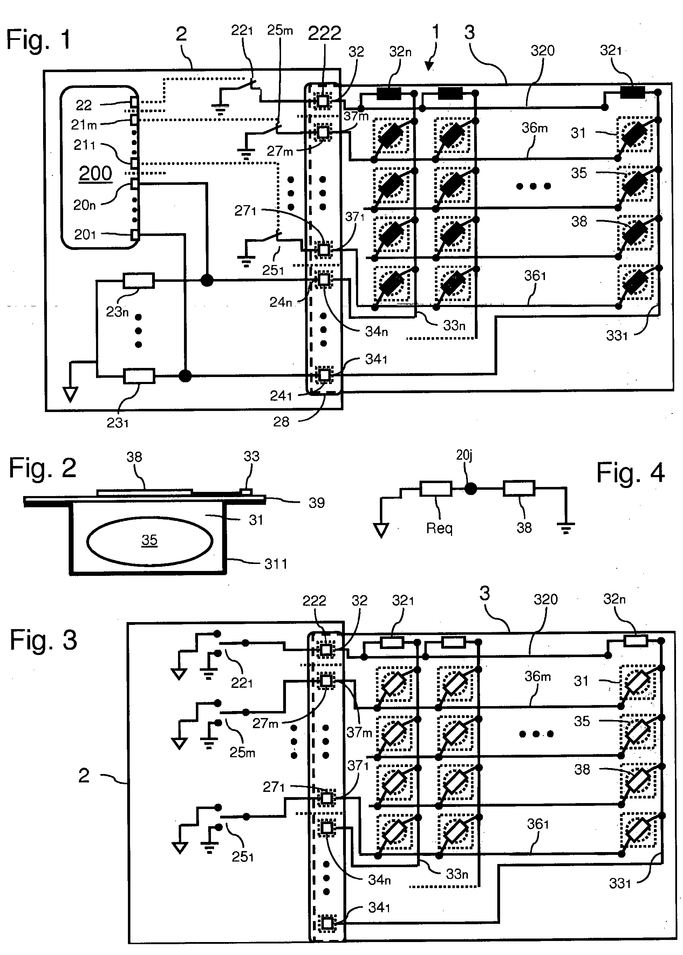

La figure 1 est un schéma électrique d'un système 1 de détection d'ouverture d'un logement dans un emballage scellé, mettant en oeuvre un mode de réalisation de l'invention. Le système 1 comprend un emballage 3 et un dispositif de lecture 2. Dans ce mode de réalisation, l'emballage 3 et le dispositif de lecture 2 sont séparables, de sorte que le dispositif de lecture 2 (incluant potentiellement des circuits électroniques coûteux) puisse être conservé, alors que l'emballage 3 peut être à usage unique.

L'emballage 3 comporte de façon connue en soi une matrice de logements 31, ou alvéoles, ménagés dans une coque 311, de manière à définir un plateau alvéolé. Comme illustré à la figure 2, les logements 31, contiennent une dose de substance, solide ou liquide, destinée à être administrée. Ladite substance peut notamment être un médicament. Les logements 31 sont répartis selon deux axes, en lignes et colonnes. Chaque ligne correspond par exemple à un moment de prise durant une journée, chaque colonne pouvant par exemple correspondre à une journée distincte. Chaque logement 31 est scellé hermétiquement de façon connue en soi par une membrane sécable 39. Une membrane sécable 39 est conçue pour être rompue et présente généralement une résistance à la rupture nettement inférieure à celle de la coque 311. La membrane sécable 39 peut être réalisée d'un seul tenant pour l'ensemble des logements 31 ou chacun des logements 31 peut comporter une membrane 39 individualisée.

La membrane 39 comprend en outre des pistes conductrices réparties en lignes $36_1$ à $36_m$ et des pistes conductrices réparties en colonnes $33_1$ à $33_n$. Une piste conductrice de colonne 33 est illustrée pour le logement de la figure 2. Les pistes de lignes et de colonnes correspondent à des lignes et colonnes respectives de logements 31. Ainsi, la membrane 39 est divisée en cellules élémentaires $39_{ij}$, chaque cellule $39ij$ étant délimitée par une ligne $36i$ et une colonne $33j$. On entend par cela que les lignes $36i$ et colonnes $33j$ sont positionnées au moins en partie sur le contour des cellules élémentaires, ou encore que chaque cellule élémentaire $39ij$ de la membrane est encadrée ou entourée au moins en partie par les lignes/colonnes. Chaque cellule de la membrane $39_{ij}$ comprend en outre un composant électrique $38_{ij}$. Chaque composant électrique $38_{ij}$ est connecté électriquement entre la piste de la ligne $36i$ et la piste de la colonne $33j$ délimitant une cellule $39_{ij}$. Dans l'exemple illustré, chaque cellule $39_{ij}$ est disposée à l'aplomb d'un logement 31, le composant $38_{ij}$ qu'elle comporte étant formé sur une face de la membrane sécable 39 en regard du logement 31. Dans les exemples représentés, les composants $38_{ij}$ sont identiques pour chaque cellule $39_{ij}$ de la membrane.

Chaque composant électrique $38ij$ et/ou ses connexions à sa ligne et/ou à sa colonne respectives sont conçus de sorte que lorsque la membrane 39 est rompue, au niveau de la cellule $39_{ij}$, pour accéder au contenu du logement 31, le composant $38ij$ ou une de ses connexions à la ligne $36i$ ou à la colonne $33j$ est suffisamment détérioré pour interrompre la conduction entre la ligne et la colonne délimitant ladite cellule, par l'intermédiaire du composant $38_{ij}$. Cependant, l'opération d'ouverture de la membrane au niveau d'une cellule élémentaire $39_{ij}$ ne détériore ni la ligne $36i$ adjacente, ni la colonne $33j$ adjacente, qui elles restent intactes (seule la liaison par l'intermédiaire du composant $38ij$ est altérée par l'ouverture de la membrane au niveau de la cellule $39_{ij}$. Pour protéger les lignes $36i$ et colonnes $33j$, celles-ci peuvent avantageusement être déportées par rapport à chacun des logements 31, de sorte que l'ouverture de la membrane 39 n'altère pas ces pistes conductrices. Par déporté, on entend que les lignes $36i$ et colonnes $33j$ ne passent pas à l'aplomb des logements 31. Les composants $38ij$ sont déportés par rapport aux lignes $36i$ et colonnes $33j$, de sorte que l'altération d'un composant $38ij$ ou de sa connexion à la ligne $36i$ et à la colonne $33j$ n'induise pas l'altération de cette ligne $36i$ et de cette colonne $33j$. L'altération d'un composant $38ij$ n'empêche alors pas une détection dans le reste de la ligne $36i$ et dans le reste de la colonne $33j$.

La membrane 39 peut comporter en outre une ligne de composants de contrôle $32_1$ à $32_n$. Chaque composant de contrôle est connecté entre d'une part une piste de contrôle 320 et d'autre part une colonne respective parmi les colonnes $33_1$ à $33_n$. La fonction de ces composants de contrôle, optionnels, sera détaillée ensuite.

La membrane 39 et le dispositif de lecture 2 étant indépendants, ils disposent d'une interface d'interconnexion. La membrane 39 comporte ainsi des plots de connexion $37_1$ à $37_m$, connectés à une extrémité de pistes de lignes respectives $36_1$ à $36_m$. Les plots de connexion $37_1$ à $37_m$ sont destinés à être connectés électriquement à des plots de connexion respectifs $27_1$ à $27_m$ du dispositif de lecture 2. La membrane 39 comporte également des plots de connexion $34_1$ à $34_n$, connectés à une extrémité de pistes de colonnes respectives $33_1$ à $33_n$. Les plots de connexion $34_1$ à $34_n$ sont destinés à être connectés électriquement à des plots de connexion respectifs $24_1$ à $24_n$ du dispositif de lecture 2. La membrane 39 comporte en outre un plot de connexion 32 connecté à une extrémité de la piste de contrôle 320. Le plot de connexion 32 est destiné à être connecté électriquement à un plot de connexion respectif 222 du dispositif de lecture 2.

Le dispositif de lecture 2 présente par exemple une prise femelle 28 pour l'insertion d'une bordure de l'emballage 3, de sorte que les plots respectifs du dispositif de lecture 2 et de la membrane 39 de l'emballage 3 soient en contact.

Les plots de connexion $24_1$ à $24_n$ du dispositif de lecture 2 sont connectés respectivement à un premier potentiel (ici un potentiel Vdd), par l'intermédiaire de résistances, dites résistances_de pull-up respectives $23_1$ à $23_n$. Ainsi, chaque colonne $33j$ est raccordée audit premier potentiel par l'intermédiaire d'une résistance $23_i$. Ces résistances, disposées entre une alimentation et un point de mesure, forment, avec les composants $38_{ij}$ de la membrane 39, un pont diviseur. Cela permet de mesurer une tension, entre lesdits composants $38_{ij}$ et la membrane 39, ladite tension comportant une information quant à l'état des cellules (ouvert ou fermé) de la membrane.

Le dispositif de lecture 2 présente en outre un circuit de commande et de traitement 200, par exemple sous la forme d'un microcontrôleur. Le circuit 200 est connecté par une entrée de mesure respective ($20_1$ à $20_n$) à un point intermédiaire entre chaque résistance et son plot de connexion respectif de la prise femelle 28.

Le dispositif de lecture 2 comporte en outre des commutateurs $25_1$ à $25_m$. Les commutateurs $25_1$ à $25_m$ sont aptes à connecter sélectivement les plots de connexion $27_1$ à $27_m$ à un point de test, porté à un deuxième potentiel (ici un potentiel de masse). Le circuit 200 comporte en outre des sorties de commande $21_1$ à $21_m$. Chaque sortie de commande $21_1$ à $21_m$ commande un commutateur $27_1$ à $27_m$ respectif.

Le dispositif de lecture 2 peut comporter en outre un commutateur 221. Le circuit 200 comporte en outre une sortie 22. La sortie 22 commande le commutateur 221, de façon à ce que le plot de connexion 222 puisse être connecté audit deuxième potentiel.

Lorsque le circuit 200 souhaite déterminer l'ouverture d'une cellule $39_{ij}$ de la membrane sécable, au niveau d'une ligne i et à une colonne j, il ferme le commutateur $25_i$, de telle sorte que la piste conductrice de ligne i est alors connectée au deuxième potentiel, c'est-à-dire le potentiel de masse. La piste conductrice de colonne j est connectée au premier potentiel, c'est-à-dire le potentiel Vdd, par l'intermédiaire de la résistance $23_j$. En fonction de la détérioration ou non du composant $38_{ij}$ de la ligne i et de la colonne j, où de ses connexions aux pistes conductrices de ligne i ou de colonne j, le potentiel de mesure Aj, sur l'entrée de mesure $20_j$ (connectée à la piste conductrice de colonne j) est différent, du fait de la formation ou non d'un circuit entre les premier et deuxième potentiels dans le dispositif de lecture 2. Par conséquent, le circuit 200 est apte à déterminer l'absence de conduction par le composant 38ij concerné, afin d'identifier une rupture de sa membrane 39 au niveau de la cellule (i,j). Autrement dit, en mesurant le signal électrique à l'entrée de mesure 20j, il est possible de déterminer l'état de la cellule $39_{ij}$. Par état de la cellule, on entend une cellule ouverte ou fermée. On peut ainsi considérer que le dispositif de lecture 2 effectue une alimentation électrique par l'intermédiaire des pistes de lignes, et une lecture par l'intermédiaire des pistes de colonnes.

Pour détecter l'accès à un logement 31 parmi M * N logements, la membrane 39 ne nécessite que M + N pistes conductrices. Par conséquent, un nombre limité de pistes conductrices peut être utilisé pour un grand nombre de logements 31, ce qui permet de conserver une membrane 39 et un emballage 3 compacts et relativement peu coûteux, et nécessitant un dispositif de lecture 2 relativement simple au niveau de ses interfaces. De plus, le connecteur 28 comporte moins de contacts, et peut alors être plus robuste.

Les composants électriques $32_1$ à $32_n$, ou composants de contrôle, connectés à la piste de contrôle 320 permettent avantageusement de d'identifier les colonnes de la membrane 39 effectivement connectées au dispositif de lecture 2. Ainsi, chaque colonne j comporte un composant de contrôle 32j permettant de relier la piste de contrôle 320 à un plot 24j. Ces composants de contrôle 32j ne sont pas situés dans une cellule de la membrane, destinée à être rompue, mais en périphérie des cellules définies sur la membrane 39. Les composants de contrôle permettent notamment de détecter l'absence d'une ou plusieurs colonnes sur la matrice, et d'identifier la ou les colonnes manquantes. Ainsi, lorsque la piste de contrôle est activée, les mesures réalisées à chaque point 24j permettent de détecter la présence ou l'absence de la colonne j. La présence de ces composants électriques est optionnelle.

La figure 3 illustre schématiquement un emballage 3 avec une membrane sécable selon une première variante de l'invention, dans laquelle les composants électriques 38 sont des résistances (de même que les composants de contrôle $32_1$ à $32_n$). Les commutateurs $25_1$ à $25_m$ raccordent ici sélectivement les plots de connexion $27_1$ à $27_m$ (et donc les pistes de lignes $36_1$ à $36_m$) au premier potentiel ou au deuxième potentiel. En l'absence de test d'une cellule $39_{ij}$ délimitée au moins en partie par une ligne i, le commutateur $25_i$ connecte la piste de ligne i au premier potentiel (potentiel Vdd), afin d'éviter une circulation de courant entre une ligne testée et une ligne non testée lorsqu'un composant $38_{ij}$ n'assure pas la conduction entre une ligne i et une colonne j, une telle circulation pouvant masquer l'effet de l'ouverture d'une cellule. Ainsi, le fait de maintenir les extrémités des lignes non testées à un potentiel identique au premier potentiel, en l'occurrence $V_{dd}$, permet d'assurer la fiabilité de la mesure.

Le système 1 utilisant une telle membrane 39 d'emballage 3 et un tel dispositif de lecture 2 met en oeuvre une détection d'ouverture d'un logement 31 par l'intermédiaire d'un principe de diviseur de tension illustré à la figure 4.

Pour tester une cellule disposée sur une ligne i d'une membrane 39, le commutateur $25_i$ connecte la piste de ligne i au deuxième potentiel. En fonction de la détérioration ou non de la résistance $38_{ij}$ associée à la cellule $39_{ij}$, ou de ses connexions aux pistes conductrices de ligne i ou de colonne j, le potentiel Aj sur l'entrée de mesure $20_j$ (connectée à la piste conductrice de colonne j) varie. Lorsque la conduction est interrompue, le potentiel mesuré sur l'entrée de mesure $20_j$ correspond au premier potentiel $V_{dd}$. Lorsque la résistance 38 est intacte, le potentiel sur l'entrée de mesure 20j prend une valeur intermédiaire entre les premier et deuxième potentiels, comme détaillé par la suite. La résistance Req correspond à la résistance équivalente correspondant à la mise en parallèle de la résistance de pull-up (23j) avec les résistances $38_{ij}$ des autres cellules situées sur la même colonne j et la résistance de contrôle 32j de cette colonne j. On notera Aj la valeur de potentiel mesurée à l'entrée de mesure $20_j$, ce potentiel étant appelé potentiel de mesure.

Lorsque la résistance 38 assure bien la conduction entre les pistes de ligne i et de colonne j, le potentiel Aj prend la valeur suivante :

$$Aj = Vdd * R38_{ij} / (R38_{ij} + Req)$$

Avec Vdd la valeur du premier potentiel et $R38_{ij}$ la valeur de la résistance 38 associée à de la cellule 39ij testée.

Avec

$$1/Req = (1 / R23j) + (1/R32j) + \Sigma (1/Rj)$$

Avec R23j la résistance du pull-up $23_j$, R32j la résistance de contrôle $32_j$, et Rj la résistance équivalente aux autres résistances $38_{ij}$ des cellules de la colonne j, différentes de la résistance associée à la cellule testée. En effet, les pistes 320, et $36_1$ à $36_m$ sont connectées au premier potentiel, à l'exception de la ligne i testée. La valeur du potentiel de mesure Aj dépend donc du nombre de résistances 38ij encore opérationnelles dans la colonne j, autres que la résistance 38 testée. On peut déterminer si la résistance 38ij assure encore la conduction entre le potentiel de repos et le potentiel de test, en comparant la valeur du potentiel de mesure Aj à un seuil.

Des tests ont été réalisés avec les valeurs suivantes :

- un premier potentiel Vdd de 15,3 V ;
- un deuxième potentiel test égal à la masse.
- des résistances R38, R32j, R23j et Rj de 5,6 kΩ ;
- quatre résistances 38 dans la colonne j ;
- un seuil de 13,7 V.

Ces tests ont permis de déterminer que la non conduction de la résistance 38 testée était discriminante par rapport au seuil choisi, les potentiels Aj suivants ayant été mesurés dans les différents cas de figure :

- un potentiel de mesure Aj = 15,3 V lorsque la résistance 38 est non conductrice (ce qui correspond au potentiel de repos), ;
- un potentiel de mesure Aj = 12,2 V lorsque la résistance 38 est conductrice et que les trois autres résistances 38 de la colonne sont également conductrices ;
- un potentiel de mesure de Aj = 11,5 V lorsque la résistance 38 est conductrice et que seulement deux autres résistances 38 de la colonne sont également conductrices ;
- un potentiel de mesure Aj = 10,2 V lorsque la résistance 38 est conductrice et que seulement une autre résistance 38 de la colonne est également conductrice ;
- un potentiel de mesure Aj = 7,7 V lorsque la résistance 38 est conductrice et qu'aucune des autres résistances 38 de la colonne n'est également conductrice.

D'autres valeurs de premier ou de deuxième potentiel, de nombre et de valeurs de résistances et/ou de seuil peuvent bien entendu être choisies.

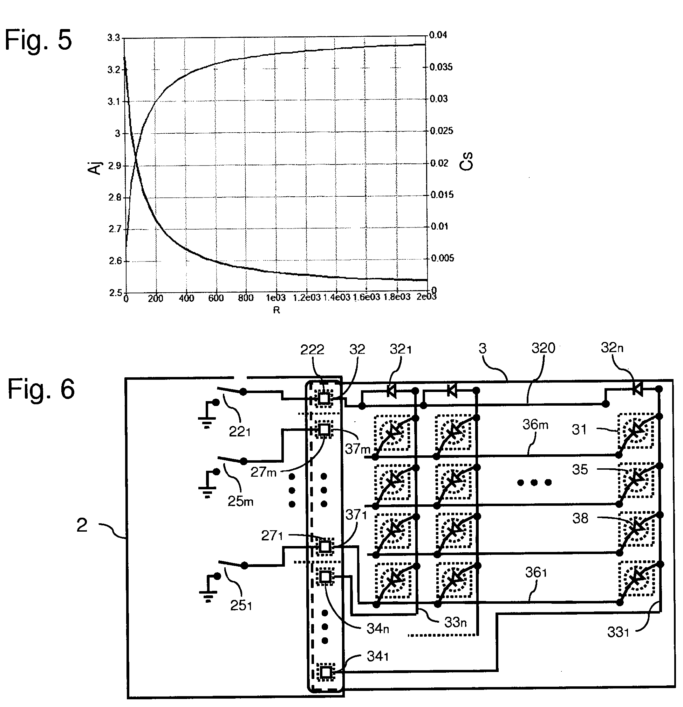

Afin d'optimiser la consommation, il est possible de disposer, entre chaque commutateur 22i et la première résistance $38_{i,j=1}$ de la colonne j=1, une résistance $40_i$, dite résistance subsidiaire associée à la ligne i. Lorsqu'une cellule 39ij d'une ligne 36i est testée, le commutateur 22i est raccordé au deuxième potentiel, ce qui permet une circulation de courant dans les colonnes 33j raccordées à la ligne 36i par l'intermédiaire d'un composant $38_{ij}$, lesdites colonnes étant connectées au premier potentiel par l'intermédiaire des résistances 23j. L'ajout d'une résistance subsidiaire 40i sur une ligne 36i permet de diminuer l'intensité du courant circulant dans la ligne, comme on peut le voir sur la figure 5.

La figure 5 est un diagramme permettant de déterminer la valeur d'une résistance subsidiaire 40i en fonction de la consommation du circuit et de la dynamique de la mesure. Dans cet exemple, le premier potentiel Vdd est égal à 3,3V. Chaque résistance R38ij associée à une ligne 36i et une colonne 33j et chaque résistance de pull up R23j a respectivement une valeur de 500Ω et 20kΩ. Une première courbe correspond à la valeur du potentiel de mesure Aj, en fonction de la valeur de la résistance subsidiaire 40i, lorsque l'ensemble des autres résistances 38 de la colonne sont opérationnelles. Cette courbe est donc représentative de la sensibilité de la détection par la différence entre cette valeur Aj et la valeur Vdd, cette dernière étant égale 3.3 V. Cette courbe représente donc la dynamique de la mesure. Une deuxième courbe correspond à la l'intensité du courant circulant dans la ligne testée en fonction en fonction de la valeur de la résistance subsidiaire 40i,. Ainsi, on doit réaliser un compromis entre une bonne sensibilité de détection et une faible consommation de courant. Dans cet exemple, une résistance de 100 Ω permet d'obtenir une marge de mesure de 0,3 V pour le potentiel de mesure Aj avec une consommation statique maximale de 15mA.

Les résistances 38 peuvent être réalisées par un dépôt métallique de forme appropriée sur un film destiné à former les membranes 39.

La figure 6 illustre schématiquement un emballage 3 selon une deuxième variante de l'invention, dans laquelle les composants électriques 38 sont des diodes (de même que les composants $32_1$ à $32_n$). Les commutateurs $25_1$ à $25_m$ raccordent ici sélectivement les plots de connexion $27_1$ à $27_m$ (et donc les pistes de lignes $36_1$ à $36_m$) au deuxième potentiel (ce dernier pouvant être un potentiel fixe ou flottant). En l'absence de test d'une cellule disposée sur la ligne 36i de la membrane 39, le commutateur $25_i$ connecte la piste de ligne i au potentiel flottant. Il n'est pas nécessaire de connecter les plots de connexion au premier potentiel Vdd en dehors des phases de test, les diodes utilisées évitant intrinsèquement les circulations de courant précédemment décrites. La structure du dispositif de lecture 2 peut ainsi être simplifiée.

Dans le cas d'un potentiel d'alimentation positif, l'anode de chacune des diodes 38 est connectée à une piste de colonne respective, la cathode de chacune de ces diodes 38 étant connectée à une piste de ligne respective. L'anode de chacune des diodes $32_1$ à $32_n$ est connectée à une piste de colonne respective, la cathode de chacune de ces diodes étant connectée à la piste de contrôle 320.

Pour tester les cellules $39_{ij}$ d'une ligne 36i, le commutateur $25_i$ connecte la piste de ligne i au deuxième potentiel, en l'occurrence la masse. En fonction de la détérioration ou non de la diode $38_{ij}$ de la ligne i et de la colonne j, ou de ses connexions aux pistes conductrices de ligne i ou de colonne j, le potentiel de mesure Aj sur l'entrée de mesure $20_j$ (connectée à la piste conductrice de colonne j) est différent.

Lorsque la connexion de la diode 38 à ses pistes de ligne et de colonne est interrompue, le potentiel sur l'entrée de mesure $20_j$ correspond au premier potentiel Vdd. Lorsque la diode 38 est intacte, le potentiel sur l'entrée de mesure $20_j$ est égal au deuxième potentiel, en l'occurrence la masse. La lecture du potentiel Aj appliqué sur l'entrée de mesure $20_j$ est indépendante de l'état des autres diodes 38 de la colonne j. En outre, l'application du potentiel de mesure Aj sur le circuit de traitement 200 ne nécessite pas de circuit analogique de mesure ou de comparateur pour déterminer l'état de la diode 38 testée.

Les diodes 38 et $32_1$ à $32_n$ peuvent être réalisées par impression ou dépôt de matériaux semi-conducteurs sur un film destiné à former les membranes 39.

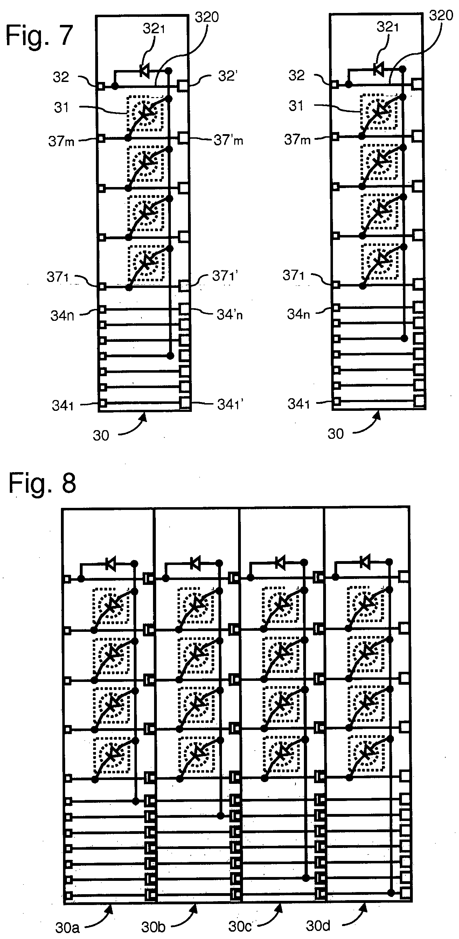

La figure 7 illustre un mode de réalisation, selon lequel des logements 31 d'un emballage 3 peuvent être sélectivement séparés ou réunis. Ces logements 31 sont destinés à être séparés pour éventuellement présenter un encombrement moindre lors d'un déplacement, et afin de pouvoir les réunir et déterminer les médications effectivement utilisées durant ce déplacement.

Ainsi, la membrane 39 peut être divisée en une pluralité d'éléments 30, chaque élément 30 comportant par exemple des cellules 39ij disposées le long d'une même colonne 33j. Les composants électriques illustrés ici sont des diodes mais ce perfectionnement peut également s'appliquer à d'autres composants électriques, telles que les résistances décrites précédemment.

À cet effet, chaque élément 30 comporte une piste de colonne 39j, une portion de la piste de contrôle 320, et une portion des pistes de ligne $36_1$ à $36_m$. La portion de piste de contrôle 320 est connectée d'une part à un plot de connexion de sortie 32 et à un plot de connexion d'entrée 32'. Les portions de piste de ligne $36_1$ à $36_m$ sont connectées d'une part à des plots de connexion de sortie $37_1$ à $37_m$ respectifs et d'autre part à des plots de connexion d'entrée $37'_1$ à $37'_m$ respectifs. Chaque élément 30 comporte des portions de piste pour les colonnes des autres éléments 30, connectées entre des plots de connexion de sortie $34_1$ à $34_n$ respectifs et des plots de connexion d'entrée $34'_1$ à $34'_n$ respectifs. Pour un élément 30 correspondant à la colonne j, la piste de colonne $33_j$ est connectée au plot de connexion de sortie $34_j$. Le plot de connexion d'entrée $34'_j$ n'est pas connecté au plot de connexion de sortie $34_j$ de ce même élément 30, afin d'éviter de réaliser une détection de deux colonnes identiques. Les plots de connexion d'entrée et les plots de connexion de sortie de deux éléments 30 assemblées sont ainsi placés en contact afin de reformer les pistes conductrices de lignes et de colonnes pour permettre au dispositif de lecture 2 de tester l'accès aux différents logements 31 connectés. On constate que le dispositif de lecture peut identifier l'élément 30 testé, en particulier au moyen de la piste de contrôle 320. En effet, lorsque le commutateur de contrôle 32 raccorde la ligne de contrôle 320 à un potentiel différent du potentiel Vdd, et par exemple à la masse, on peut réaliser une mesure sur chaque point de mesure 20j afin de vérifier l'absence ou la présence des cellules 39ij appartenant à une même colonne 33j. La valeur du potentiel de mesure Aj dépend alors de la présence ou de l'absence desdites cellules.

Sur l'exemple de la figure 8, on n'a conservé que des colonnes 30a, 30b, 30c et 30d, qui sont assemblées. Dans cet exemple, les 3 ième à 5 ième colonnes ont été retirées, le potentiel de mesure est Aj est nul lorsque j = 3 4 ou 5, ce qui indique qu'un élément 30, rassemblant les cellules des troisième cinquième colonnes, a été retiré.

L'emballage 3 peut se présenter sous forme d'éléments 30 initialement d'un seul tenant, cet emballage 3 pouvant être conçu pour scinder ces éléments 30 en différentes colonnes. L'emballage 3 (de même que la membrane 39) peut par exemple comporter des amincissements ou des perçages à la jonction entre deux éléments 30 successifs. Des connexions mâle/femelle peuvent être conçues afin de fixer ensemble des éléments 30 ayant été scindés.

Les membranes 39 peuvent être fixées sur la coque 311 sous forme d'un même film, par exemple un film autocollant sur lequel sont formés les pistes conductrices et/ou les composants électriques 38. Les pistes conductrices et les composants électriques 38 peuvent être ménagés sur la face interne d'un tel film afin de limiter leurs risques d'altération.

Afin de garantir que la connexion du composant électrique à une piste de ligne ou de colonne soit bien rompue à l'aplomb d'un logement 31, on peut par exemple prévoir que cette connexion s'étende de façon linéaire sur la majeure partie de la membrane 39 à l'aplomb d'un logement 31, de sorte que toute rupture de la membrane 39 aboutisse à une rupture de cette connexion linéaire.

Pour protéger au contraire les pistes de ligne et de colonne d'un composant électrique lors de la rupture de ce composant électrique 38 qui les connecte, ces pistes de ligne et de colonne sont avantageusement déportées par rapport à chaque logement 31 et par rapport à ce composant électrique 38.

Le dispositif de lecture 2 peut avantageusement présenter différentes fonctions de communication. Le dispositif de lecture 2 peut par exemple disposer d'une référence temporelle et mémoriser des plages horaires pour l'accès à des logements 31. Le dispositif de lecture 2 peut par exemple avertir le patient de la nécessité de prendre ses médicaments pendant une plage horaire donnée, ou avertir du personnel médical d'un défaut de prise de médicaments ou d'une prise de médicaments dans un logement erroné.

## Revendications

1. Membrane sécable (39) comportant :

   - des pistes conductrices réparties en lignes ($36_1$, $36_m$) ;
   - des pistes conductrices réparties en colonnes ($33_1$, $33_n$) ;
   - des cellules élémentaires ($39_{ij}$) sécables,

   **Caractérisée en ce que** :

   le contour de chaque cellule étant au moins en partie délimité par une desdites pistes de ligne (36i) et une desdites pistes de colonne: (33j),
   chaque cellule élémentaire comportant un composant électrique ($38_{ij}$), connecté électriquement entre une piste conductrice (36i) d'une ligne respective et une piste conductrice (33j) d'une colonne respective.

2. Membrane selon la revendication 1, incluant un même film sur lequel sont ménagés lesdites pistes conductrices et lesdits composants électriques.

3. Membrane selon l'une quelconque des revendications 1 ou 2, dans laquelle chaque composant électrique (38ij) est déporté par rapport à la piste conductrice (36i) de sa ligne respective et par rapport à la piste conductrice (33j) de sa colonne respective.

4. Système comportant une membrane selon l'une quelconque des revendications 1 à 3 et un dispositif de lecture (2), comprenant un circuit de commande et de traitement (200) apte à :

   - connecter chaque piste conductrice de colonne (33j) à un premier potentiel ;
   - connecter sélectivement une piste conductrice de ligne (36j) à un deuxième potentiel différent du premier potentiel ;
   - déterminer l'absence de conduction électrique entre une piste de ligne et une piste de colonne données, lorsque la piste conductrice de cette ligne est connectée au deuxième potentiel ;
   - identifier une rupture d'une cellule ($39_{ij}$) à la ligne (36i) et la colonne (33j) correspondant à l'absence de conduction électrique déterminée.

5. Système selon la revendication 4, dans lequel le premier potentiel est supérieur au deuxième potentiel, et dans lequel lesdits composants électriques (38) sont des diodes dont l'anode est connectée au premier potentiel et dont la cathode est connectée sélectivement au deuxième potentiel.

6. Système selon la revendication 4, dans lequel lesdits composants électriques (38) sont des résistances.

7. Système selon la revendication 6, dans lequel ledit dispositif de lecture comprend des commutateurs ($25_1$, $25_m$) connectant sélectivement des pistes conductrices de ligne respectives ($36_1$, $36_m$) au premier potentiel ou au deuxième potentiel, ledit circuit de commande et de traitement (200) étant configuré pour connecter simultanément seulement une desdites pistes conductrices de ligne audit deuxième potentiel.

8. Système de détection selon l'une quelconque des revendications 4 à 7, dans lequel la membrane (39) est scindable en éléments (30) de colonnes distincts, lesdits éléments présentant chacun une portion desdites pistes conductrices de lignes et étant configurés pour s'assembler de façon à former lesdites pistes conductrices de lignes ($36_1$, $36_m$) et lesdites pistes conductrices de colonnes ($33_1$, $33_n$).

9. Système selon l'une quelconque des revendications 4 à 8, dans lequel la membrane (3) comporte en outre une piste conductrice de contrôle (320) et comporte des composants électriques de contrôle ($32_1$, $32_n$) connectés entre la piste conductrice de contrôle et des pistes conductrices de colonne respectives, ledit circuit de commande et de traitement (200) étant configuré pour connecter sélectivement ladite piste de contrôle au deuxième potentiel.

10. Système selon l'une quelconque des revendications 4 à 9, dans lequel ledit dispositif de lecture (2) comporte une interface ($24_1$, $34_1$, $24_n$, $34_n$) connectant les pistes de conduction de colonne à un premier potentiel et comportent des plots de connexion connectés à des pistes de conduction de colonne respectives, le dispositif de lecture (2) comportant des résistances de pull-up ($23_1$, $23_n$) connectées à des plots de connexion respectifs ($24_1$, $24_{1n}$), ledit circuit de commande et de traitement (200) étant configuré pour mesurer la tension entre une résistance de pull-up et un plot de connexion respectif afin de déterminer ladite absence de conduction électrique.

11. Système selon les revendications 7 et 10, dans lequel ledit circuit de commande et de traitement (200) comporte un comparateur comparant ladite tension mesurée à un seuil de référence pour déterminer ladite absence de conduction électrique.

12. Système de détection selon l'une quelconque des revendications 4 à 11, dans lequel la membrane (39) et le dispositif de lecture (2) sont configurés pour être sélectivement interconnectés ou séparés.

13. Système de détection selon l'une quelconque des revendications 4 à 12, comprenant une matrice de logements (31) répartis selon lesdites lignes et lesdites colonnes, chacun desdits logements étant scellé par la membrane et étant disposé sous une cellule élémentaire respective.

14. Système de détection selon la revendication 13, dans lequel lesdites pistes de ligne (36i) et lesdites pistes de colonne (33j) sont déportées par rapport auxdits logements (31).

## Patentansprüche

1. Trennbare Membran (39), umfassend:

   - Leiterbahnen, die in Zeilen ($36_1$, $36_m$) verteilt sind;
   - Leiterbahnen, die in Spalten ($33_1$, $33_n$) verteilt sind;
   - trennbare Elementarzellen ($39_{ij}$),

   **dadurch gekennzeichnet, dass**:

   die Kontur von jeder Zelle mindestens teilweise durch eine der Zeilenleiterbahnen (36i) und eine der Spaltenleiterbahnen (33j) begrenzt ist,
   wobei jede Elementarzelle eine elektrische Komponente (38ij) aufweist, die zwischen einer Leiterbahn (36i) einer jeweiligen Zeile und einer Leiterbahn (33j) einer jeweiligen Spalte elektrisch angeschlossen ist.

2. Membran nach Anspruch 1, die eine gleiche Folie aufweist, auf der die Leiterbahnen und die elektrischen Komponenten angeordnet sind.

3. Membran nach einem der Ansprüche 1 bis 2, wobei jede elektrische Komponente (38ij) bezogen auf die Leiterbahn (36i) ihrer jeweiligen Zeile und bezogen auf die Leiterbahn (33j) ihrer jeweiligen Spalte versetzt ist.

4. System, umfassend eine Membran nach einem der Ansprüche 1 bis 3 und eine Lesevorrichtung (2), umfassend einen Steuer- und Verarbeitungskreis (200), der geeignet ist:

   - jede Spaltenleiterbahn (33j) an ein erstes Potential anzuschließen;
   - selektiv eine Zeilenleiterbahn (36j) an ein zweites Potential anzuschließen, das sich von dem ersten Potential unterscheidet;
   - das Nichtvorhandensein von Stromfluss zwischen einer gegebenen Zeilenleiterbahn und einer gegebenen Spaltenleiterbahn zu bestimmen, wenn die Leiterbahn dieser Zeile an das zweite Potential angeschlossen ist;
   - einen Bruch einer Zelle ($39_{ij}$) an der Zeile (36i) und der Spalte (33j) zu ermitteln, der dem bestimmten Nichtvorhandensein von Stromfluss entspricht.

5. System nach Anspruch 4, wobei das erste Potential höher als das zweite Potential ist, und wobei die elektrischen Komponenten (38) Dioden sind, wovon die Anode an das erste Potential angeschlossen ist und wovon die Kathode selektiv an das zweite Potential angeschlossen ist.

6.  System nach Anspruch 4, wobei die elektrischen Komponenten (38) Widerstände sind.

7.  System nach Anspruch 6, wobei die Lesevorrichtung Wahlschalter ($25_1$, $25_m$) aufweist, die selektiv die jeweiligen Zeilenleiterbahnen ($36_1$, $36_m$) an das erste Potential oder an das zweite Potential anschließen, wobei der Steuer- und Verarbeitungskreis (200) konfiguriert ist, um gleichzeitig nur eine der Zeilenleiterbahnen an das zweite Potential anzuschließen.

8.  Detektionssystem nach einem der Ansprüche 4 bis 7, wobei die Membran (39) in einzelne Spaltenelemente (30) teilbar ist, wobei die Elemente jeweils einen Abschnitt der Zeilenleiterbahnen aufweisen und konfiguriert sind, um sich derart zusammenzusetzen, dass sie die Zeilenleiterbahnen ($36_1$, $36_m$) und die Spaltenleiterbahnen ($33_1$, $33_n$) bilden.

9.  System nach einem der Ansprüche 4 bis 8, wobei die Membran (3) ferner eine Kontrollleiterbahn (320) aufweist und elektrische Kontrollkomponenten ($32_1$, $32_n$) aufweist, die zwischen der Kontrollleiterbahn und den jeweiligen Spaltenleiterbahnen angeschlossen sind, wobei der Steuer- und Verarbeitungskreis (200) konfiguriert ist, um selektiv die Kontrollleiterbahn an das zweite Potential anzuschließen.

10. System nach einem der Ansprüche 4 bis 9, wobei die Lesevorrichtung (2) eine Schnittstelle ($24_1$, $34_1$, $24_n$, $34_n$) aufweist, die die Spaltenleiterbahnen an ein erstes Potential anschließt, und Verbindungskontakte aufweisen, die an die jeweiligen Spaltenleiterbahnen angeschlossen sind, wobei die Lesevorrichtung (2) Pull-Up-Widerstände ($23_1$, $23_n$) aufweist, die an die jeweiligen Verbindungskontakte ($24_1$, $24_{1n}$) angeschlossen sind, wobei der Steuer- und Verarbeitungskreis (200) konfiguriert ist, um die Spannung zwischen einem Pull-Up-Widerstand und einem jeweiligen Verbindungskontakt zu messen, um das Nichtvorhandensein von Stromfluss zu bestimmen.

11. System nach einem der Ansprüche 7 und 10, wobei der Steuer- und Verarbeitungskreis (200) einen Komparator aufweist, der die gemessene Spannung mit einem Referenz-Schwellenwert vergleicht, um das Nichtvorhandensein von Stromfluss zu bestimmen.

12. Detektionssystem nach einem der Ansprüche 4 bis 11, wobei die Membran (39) und die Lesevorrichtung (2) konfiguriert sind, um selektiv untereinander verbunden oder voneinander getrennt zu werden.

13. Detektionssystem nach einem der Ansprüche 4 bis 12, umfassend eine Matrize von Aufnahmen (31), die nach den Zeilen und Spalten verteilt sind, wobei jede der Aufnahmen von der Membran versiegelt ist und unter einer jeweiligen Elementarzelle angeordnet ist.

14. Detektionssystem nach Anspruch 13, wobei die Zeilenleiterbahnen (36i) und die Spaltenleiterbahnen (33j) bezogen auf die Aufnahmen (31) versetzt sind.

## Claims

1.  Divisible membrane (39) comprising:

    - conductive tracks distributed in rows ($36_1$, $36_m$);
    - conductive tracks distributed in columns ($33_1$, $33_n$);
    - divisible individual cells ($39_{ij}$),

    **characterized in that**
    the outline of each cell being at least partly delimited by one of said row tracks (36i) and one of said column tracks (33j), each individual cell comprising an electrical component (38ij), electrically connected between a conductive track (36i) of a respective row and a conductive track (33j) of a respective column.

2.  Membrane according to Claim 1, including one and the same film on which said conductive tracks and said electrical components are formed.

3.  Membrane according to any one of Claims 1 and 2, in which each electrical component (38ij) is offset relative to the conductive track (36i) of its respective row and relative to the conductive track (33j) of its respective column.

4. System comprising a membrane according to any one of Claims 1 to 3 and a reading device (2), comprising a control and processing circuit (200) suitable for:

- connecting each column conductive track (33j) to a first potential;
- selectively connecting a row conductive track (36j) to a second potential different from the first potential;
- determining the absence of electrical conduction between a given row track and a given column track, when the conductive track of this row is connected to the second potential;
- identifying a breaking of a cell ($39_{ij}$) on the row (36i) and the column (33j) corresponding to the determined absence of electrical conduction.

5. System according to Claim 4, in which the first potential is greater than the second potential, and in which said electrical components (38) are diodes whose anode is connected to the first potential and whose cathode is connected selectively to the second potential.

6. System according to Claim 4, in which said electrical components (38) are resistors.

7. System according to Claim 6, in which said reading device comprises switches ($25_1$, $25_m$) selectively connecting respective row conductive tracks ($36_1$, $36_m$) to the first potential or to the second potential, said control and processing circuit (200) being configured to simultaneously connect only one of said row conductive tracks to said second potential.

8. Detection system according to any one of Claims 4 to 7, in which the membrane (39) can be split into distinct column elements (30), said elements each having a portion of said row conducive tracks and being configured to be joined so as to form said row conductive tracks ($36_1$, $36_m$) and said column conductive tracks ($33_1$, $33_n$).

9. System according to any one of Claims 4 to 8, in which the membrane (3) also comprises a control conductive track (320) and comprises control electrical components ($32_1$, $32_n$) connected between the control conductive track and respective column conductive tracks, said control and processing circuit (200) being configured to selectively connect said control track to the second potential.

10. System according to any one of Claims 4 to 9, in which said reading device (2) comprises an interface ($24_1$, $34_1$, $24_n$, $34_n$) connecting the column conductive tracks to a first potential and comprise connection studs connected to respective column conductive tracks, the reading device (2) comprising pull-up resistors ($23_1$, $23_n$) connected to respective connection studs ($24_1$, $24_{1n}$), said control and processing circuit (200) being configured to measure the voltage between a pull-up resistor and a respective connection stud in order to determine said absence of electrical conduction.

11. System according to Claims 7 and 10, in which said control and processing circuit (200) comprises a comparator comparing said measured voltage to a reference threshold to determine said absence of electrical conduction.

12. Detection system according to any one of Claims 4 to 11, in which the membrane (39) and the reading device (2) are configured to be selectively interconnected or separated.

13. Detection system according to any one of Claims 4 to 12, comprising a matrix of pockets (31) distributed along said rows and said columns, each of said pockets being sealed by the membrane and being arranged under a respective individual cell.

14. Detection system according to Claim 13, in which said row tracks (36i) and said column tracks (33j) are offset relative to said pockets (31).

Fig. 1

Fig. 2

Fig. 4

Fig. 3

EP 2 826 456 B1

Fig. 5

Fig. 6

12

Fig. 7

Fig. 8

**EP 2 826 456 B1**

**RÉFÉRENCES CITÉES DANS LA DESCRIPTION**

**Documents brevets cités dans la description**

- WO 0154646 A